# EUROPEAN PATENT APPLICATION

(11) **EP 4 611 041 A1**
(43) Date of publication of application: **03.09.2025**
(21) Application number: 24160686.2
(22) Date of filing: 29.02.2024
(51) Int. Cl.: H01L 27/02

(54) **A THREE PIN CURRENT TRIGGERED TVS PROTECTION SEMICONDUCTOR DEVICE**

(71) Applicant: Nexperia B.V., 6534 AB Nijmegen (NL)
(72) Inventor: Holland, Steffen, Hamburg (DE); Ritter, Hans-Martin, Hamburg (DE)
(74) Representative: Pjanovic, Ilija

(57) **Abstract**

A transient voltage suppressor (TVS) protection device is presented comprising: an input terminal; an integrated circuit (IC) terminal, a ground terminal; a resistor connected between the input terminal and the IC terminal; and a semiconductor device arranged to be triggered by a voltage drop across the resistor to open a path between the input terminal to the ground terminal.

## Description

### Technical field

The present disclosure relates to electrostatic discharge (ESD) protection devices, and more specifically to transient voltage suppressor (TVS) protection semiconductor devices.

### Background

ESD protection devices and transient voltage suppressor (TVS) protection devices may be used to safeguard electronic circuits against electrical threats. ESD protection devices protect electronic components from damage caused by electrostatic discharge events, i.e., sudden, high-voltage discharge of static electricity. ESD protection devices enable the energy associated with electrostatic discharge to be quickly diverted and dissipated to prevent damaging sensitive components. TVS protection devices provide protection against transient voltage spikes or surges, which may be caused by various factors, including lightning, power grid fluctuations, or inductive loads switching off. TVS protection devices enable the voltage to clamp to a safe level and absorb the transient energy.

ESD protection devices are typically placed at input/output ports, terminals, and other points where the circuit is susceptible to electrostatic discharge. TVS protection devices are typically positioned at points where transient voltage spikes are likely to enter the circuit, such as power supply lines, communication lines, or other vulnerable connections.

A system-level ESD protection device is a component or a set of components designed to protect an entire electronic system from electrostatic discharge events. It may be specifically engineered to provide comprehensive protection at the system-level, covering multiple points of entry and protecting various components within the system.

### Summary

A summary of aspects of certain examples disclosed herein is set forth below. It should be understood that these aspects are presented merely to provide the reader with a brief summary of these certain embodiments and that these aspects are not intended to limit the scope of this disclosure. Indeed, this disclosure may encompass a variety of aspects and/or a combination of aspects that may not be set forth.

The present disclosure presents an improved TVS protection device.

According to an aspect of the present disclosure, a TVS protection device is presented. The TVS protection device may include an input terminal. The TVS protection device may further include an integrated circuit (IC) terminal. The TVS protection device may further include a ground terminal. The TVS protection device may further include a resistor connected between the input terminal and the IC terminal. The TVS protection device may further include a semiconductor device arranged to be triggered by a voltage drop across the resistor to open a path between the input terminal and the ground terminal.

In an embodiment, the semiconductor device may include a first silicon-controlled rectifier (SCR). The first SCR may include a first transistor and a second transistor. A collector of the first transistor may be connected to the input terminal. An emitter of the first transistor may be in a same semiconductor region as a base of the second transistor. A base of the first transistor may be connected to a collector of the second transistor and to the IC terminal. A collector of the second transistor may be connected to the base of the first transistor and to the IC terminal. An emitter of the second transistor may be connected to the ground terminal. A base of the second transistor may be connected to the emitter of the first transistor.

In an embodiment, the semiconductor device may include a second SCR. The second SCR may include a third transistor and a fourth transistor. An emitter of the third transistor may be connected to the input terminal. A collector of the third transistor may be connected to a base of the fourth transistor. A base of the third transistor may be connected to an emitter of the fourth transistor and to the IC terminal. An emitter of the fourth transistor may be connected to the base of the second transistor and to the IC terminal. A collector of the fourth transistor may be connected to the ground terminal. A base of the fourth transistor may be connected to the collector of the first transistor.

In an embodiment, the TVS protection device may be a unidirectional SCR based protection device.

In an embodiment, the TVS protection device may be a bidirectional SCR based protection device.

In an embodiment, the semiconductor device may include a first open base transistor, such as a bipolar junction transistor (BJT). The first open base transistor may include a fifth transistor. A collector of the fifth transistor may be connected to the input terminal. An emitter of the fifth transistor may be connected to the ground terminal. A base of the fifth transistor may be connected to the IC terminal.

In an embodiment, the semiconductor device may include a second open base transistor, such as a BJT. The second open base transistor may include a sixth transistor. An emitter of the sixth transistor may be connected to the input terminal. A collector of the sixth transistor may be connected to the ground terminal. A base of the sixth transistor may be connected to the IC terminal.

In an embodiment, the TVS protection device may be a unidirectional open transistor based protection device.

In an embodiment, the TVS protection device may be a bidirectional open transistor based protection device.

In an embodiment, the TVS protection device may further include a first diode. A cathode of the first diode may be connected to the input terminal. An anode of the first diode may be connected to the ground terminal.

In an embodiment, the TVS protection device may further include a second diode. An anode of the second diode may be connected to the input terminal. A cathode of the second diode may be connected to the ground terminal.

In an embodiment, the resistor may be an internal resistor formed by a first semiconductor region in between the input connector and the IC connector. The first semiconductor region may be a part of the semiconductor device.

In an embodiment, the resistor may be an external resistor formed by a second semiconductor region in between the input connector and the IC connector. The second semiconductor region may be independent from the semiconductor device.

In an embodiment, the resistor may be an external resistor in between the input connector and the IC connector. The resistor may be located outside of a semiconductor package of the TVS protection device.

According to an aspect of the present disclosure, a semiconductor package is presented. The semiconductor package includes a TVS protection device having one or more of the above-described features. The semiconductor package may include at least three externally accessible connection points connecting to an input terminal, an IC terminal and a ground terminal, respectively, of the TVS protection device.

### Brief description of the Drawings

Embodiments of the present disclosure will now be described, by way of example only, with reference to the accompanying schematic drawings in which corresponding reference symbol indicate corresponding parts, in which:
Figs. 1-8 are schematics of example TVS protection devices;
Figs. 9-11 are three-dimensional (3D) representations of example semiconductor TVS protection devices showing different resistor implementations;
Fig. 12 is a two-dimensional (2D) cross-sectional side view of an example unidirectional semiconductor TVS protection device including a shunt diode;
Fig. 13 is a 2D cross-sectional side view of an example bidirectional semiconductor TVS protection device;
Fig. 14 is an example three-pin semiconductor package housing a TVS protection device of the present disclosure; and
Fig. 15 is a schematic of an example TVS protection device.

The figures are intended for illustrative purposes only, and do not serve as restriction of the scope of the protection as laid down by the claims.

### Detailed description

It will be readily understood that the components of the embodiments as generally described herein and illustrated in the appended figures could be arranged and designed in a wide variety of different configurations. Thus, the following more detailed description of various embodiments, as represented in the figures, is not intended to limit the scope of the present disclosure but is merely representative of various embodiments. While the various aspects of the embodiments are presented in drawings, the drawings are not necessarily drawn to scale unless specifically indicated.

The described embodiments are to be considered in all respects only as illustrative and not restrictive. The scope of the present disclosure is, therefore, indicated by the appended claims rather than by this detailed description. All changes which come within the meaning and range of equivalency of the claims are to be embraced within their scope.

Reference throughout this specification to features, advantages, or similar language does not imply that all of the features and advantages that may be realized with the present disclosure should be or are in any single example of the present disclosure. Rather, language referring to the features and advantages is understood to mean that a specific feature, advantage, or characteristic described in connection with an embodiment is included in at least one embodiment of the present disclosure. Thus, discussions of the features and advantages, and similar language, throughout this specification may, but do not necessarily, refer to the same example.

Furthermore, the described features, advantages, and characteristics of the present disclosure may be combined in any suitable manner in one or more embodiments. One skilled in the relevant art will recognize, in light of the description herein, that the present disclosure may be practiced without one or more of the specific features or advantages of a particular embodiment. In other instances, additional features and advantages may be recognized in certain embodiments that may not be present in all embodiments of the present disclosure. Reference throughout this specification to "one embodiment," "an embodiment," or similar language means that a particular feature, structure, or characteristic described in connection with the indicated embodiment is included in at least one embodiment of the present disclosure. Thus, the phrases "in one embodiment," "in an embodiment," and similar language throughout this specification may, but do not necessarily, all refer to the same embodiment.

System Level ESD TVS Protection devices may be used to protect an integrated circuit (IC) from overcurrent and overvoltages. Typically, TVS protection devices are triggered once a sufficiently high voltage is applied. This trigger can be reached if the IC's system is designed properly, i.e., a sufficiently high (parasitic) resistance and/or parasitic inductance is placed between the TVS protection device and the IC. An incorrect system design may result in insufficient protection against overcurrent and/or overvoltage.

The presented disclosure provides a solution where the TVS protection becomes independent of the system design. Hereto, a small resistor is placed in the IC path and uses the voltage drop to trigger the TVS protection, making the triggering of the TVS protection device no longer dependent on parasitic inductances or external resistors.

In an embodiment, a resistance may be added to a TVS protection device, such that the resistor becomes a part of the signal path to be protected and of the TVS protection device. Preferably, this resistor is integrated into a semiconductor device forming the TVS protection device, but the resistor may be external to the semiconductor device. The TVS protection device with added resistance may be configured such that a sufficiently high current into the IC causes a voltage drop, e.g., of around 0.7 V. This may bias a pn junction in forward direction which injects carriers and ultimately triggers the TVS protection device and divert the current away from the IC as the resistance to ground in the TVS path now has lower resistivity. The TVS protection device of the present disclosure may be implemented in various manners, e.g., using a silicon-controlled rectifier (SCR) or an open base transistor (e.g., a bipolar junction transistor, BJT). Examples hereof will be further detailed below.

ICs are typically designed to withstand around 1-2 kV of HBM (Human Body model) which is equivalent to around 0.6 to 1.2 A. With such ICs, the resistor of the TVS protection device may be dimensioned in the range of 1-2 Ohms, which is sufficiently low not to disrupt the signal integrity of the data path into the IC while enabling the TVS protection device to be triggered when needed. Depending on the system and IC design, other resistance may be used for the TVS protection device.

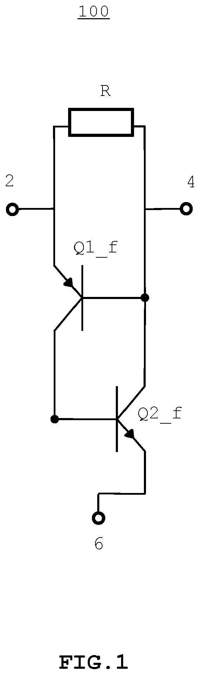

Figs. 1-8 show various non-limiting example schematics of TVS protection devices. The shown schematics may be integrated in a semiconductor device forming the TVS protection device. Different from known TVS protection devices that typically include two pins, i.e., one pin connecting to the signal line / data path to be protected and one pin connecting to ground, the TVS protection device of the present disclosure has at least three pins, i.e., two pins for placing the TVS protection device in the signal line to be protected (with a resistance in the signal path) and one pin connecting to ground.

In the following examples, Q1_f may be an NPN type transistor and Q1_r may be a PNP type transistor in case of open base transistor (e.g., BJT) based TVS protection devices.

In the following examples, in case of SCR based TVS protection devices, an SCR is represented as two transistors, i.e., a PNP transistor Q1_f and an NPN transistor Q2_f when representing a PNPN SCR, or an NPN transistor Q1_r and a PNP transistor Q2_r when representing a NPNP SCR (reversed orientation). The PNP transistor of the SCR (also known as upper transistor) represents the top portion of the SCR, with its emitter being connected to the anode, its base being connected to the gate and its collector being connected to the base of the NPN transistor. The NPN transistor of the SCR (also known as lower transistor) represents the bottom portion of the SCR, with its emitter being connected to the cathode, its base being connected to the collector of the PNP transistor and its collector being connected to the emitter of the PNP transistor.

Fig. 1 is an example embodiment of a unidirectional SCR based TVS protection device 100. Input terminal 2 may connect to an input, e.g., a signal line of a data path to be protected, IC terminal 4 may connect to an IC that is to receive signals from the signal line, and ground terminal 6 may be connected to ground. Between input terminal 2 towards the IC terminal 4 there may be a current flow through resistor R which is high enough to forwards bias Q1_f. The injected current may flow from the collector of Q1_f into the base of transistor Q2_f which forward biases the emitter of Q2_f. Eventually, a regenerative feedback loop is created which may trigger the SCR in case of an overcurrent.

A unidirectional SCR based TVS protection device for operation in the other direction, i.e., with signals in the direction from the IC (from IC terminal 4 to input terminal 2), may be realized using an SCR with Q1_r and Q2_r instead of Q1_f and Q1_f.

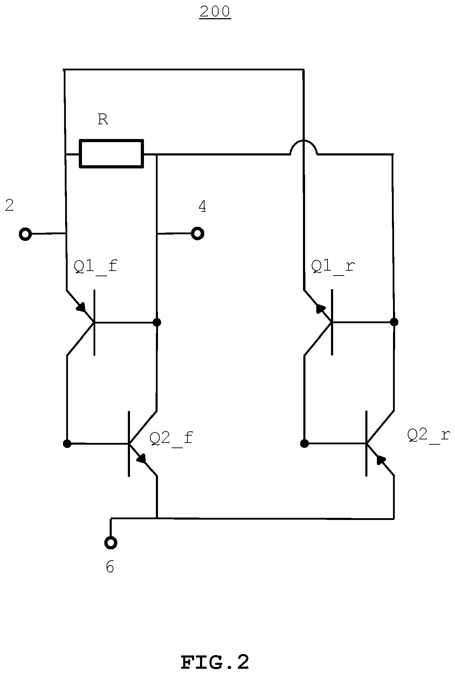

Fig. 2 is an example embodiment of a bidirectional SCR based TVS protection device 200. Input terminal 2 may connect to an input, e.g., a signal line of a data path to be protected, IC terminal 4 may connect to an IC that is to send and receive signals to/from the signal line, and ground terminal 6 may be connected to ground. In the forward path, between input terminal 2 towards the IC terminal 4 there may be a current flow through resistor R which is high enough to forwards bias Q1_f. The injected current may flow from the collector of Q1_f into the base of Q2_f which forward biases the emitter of Q2_f. Eventually, a regenerative feedback loop is created which may trigger the SCR in case of an overcurrent in the forward direction. In the reverse path, between IC terminal 4 towards the input terminal 2 there may be a current flow through resistor R which is high enough to forwards bias Q1_r. The injected current may flow from the collector of Q1_r into the base of transistor Q2_r which forward biases the emitter of Q2_r. Eventually, a regenerative feedback loop is created which may trigger the SCR in case of an overcurrent in the reverse direction.

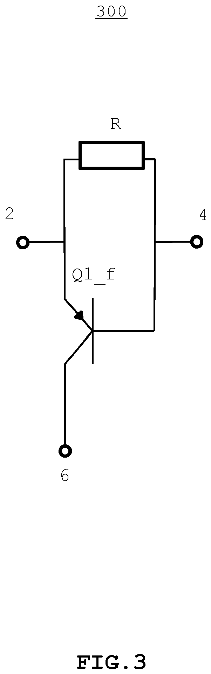

Fig. 3 is an example embodiment of a unidirectional BJT based TVS protection device 300. Input terminal 2 may connect to an input, e.g., a signal line of a data path to be protected, IC terminal 4 may connect to an IC that is to receive signals from the signal line, and ground terminal 6 may be connected to ground. Between input terminal 2 towards the IC terminal 4 there may be a current flow through resistor R which is high enough to forwards bias transistor Q1_f. Thus, a regenerative feedback loop is created which may trigger the BJT in case of an overcurrent.

A unidirectional BJT based TVS protection device for operation in the other direction, i.e., with signals in the direction from the IC (from IC terminal 4 to input terminal 2), may be realized using transistors Q1_r and Q2_r instead of Q1_f and Q1_f.

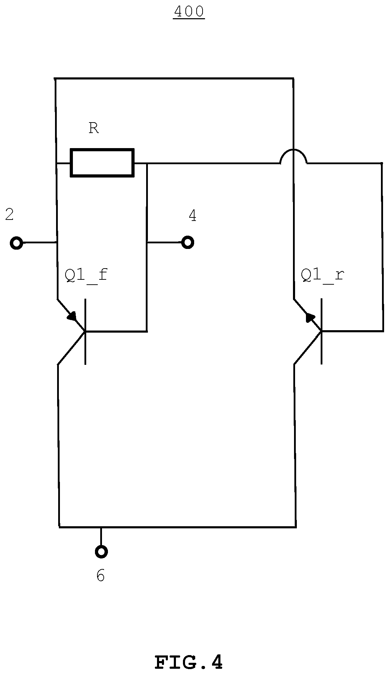

Fig. 4 is an example embodiment of a bidirectional BJT based TVS protection device 400. Input terminal 2 may connect to an input, e.g., a signal line of a data path to be protected, IC terminal 4 may connect to an IC that is to send and receive signals to/from the signal line, and ground terminal 6 may be connected to ground. In the forward path, between input terminal 2 towards the IC terminal 4 there may be a current flow through resistor R which is high enough to forwards bias transistor Q1_f. Thus, a regenerative feedback loop is created which may trigger the BJT in case of an overcurrent in the forward direction. In the reverse path, between IC terminal 4 towards the input terminal 2 there may be a current flow through resistor R which is high enough to forwards bias transistor Q1_f. Thus, a regenerative feedback loop is created which may trigger the SCR in case of an overcurrent in the reverse direction.

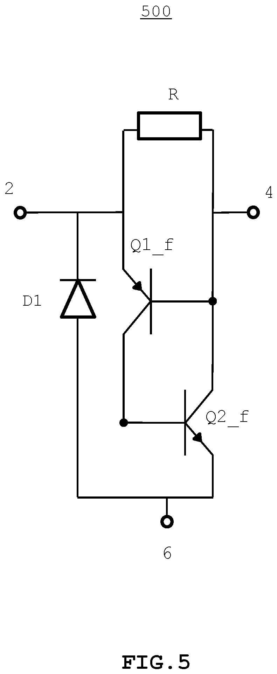

For a unidirectional device a pn junction diode may be integrated to shunt the negative direction to ground. Examples hereof are shown in Figs. 5-8.

Fig. 5 is an example embodiment of a unidirectional SCR based TVS protection device 500 similar to the unidirectional SCR based TVS protection device 100, with the addition of a diode D1 between the input terminal 2 and ground 6. Diode D1 may shunt signals in the direction from the IC terminal 4 to the input terminal 2 towards ground 6.

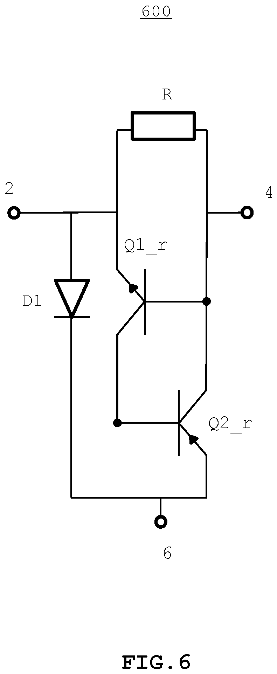

Fig. 6 is an example embodiment of a unidirectional SCR based TVS protection device 600 similar to the unidirectional SCR based TVS protection device 500 but operating in reverse direction. Diode D1 may shunt signals in the direction from the input terminal 2 to the IC terminal 4 towards ground 6.

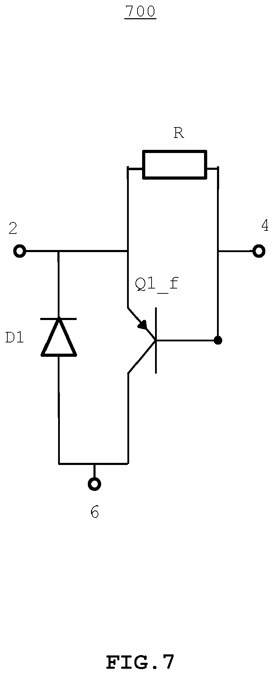

Fig. 7 is an example embodiment of a unidirectional BJT based TVS protection device 700 similar to the unidirectional BJT based TVS protection device 300, with the addition of a diode D1 between the input terminal 2 and ground 6. Diode D1 may shunt signals in the direction from the IC terminal 4 to the input terminal 2 towards ground 6.

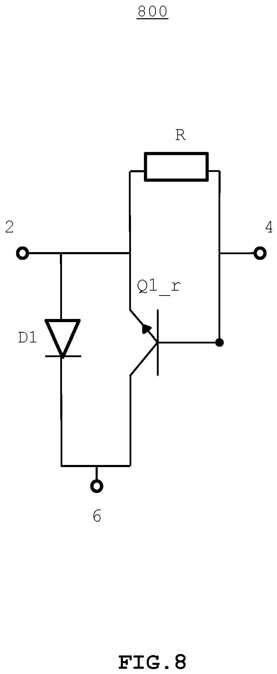

Fig. 8 is an example embodiment of a unidirectional BJT based TVS protection device 800 similar to the unidirectional BJT based TVS protection device 700 but operating in reverse direction. Diode D1 may shunt signals in the direction from the input terminal 2 to the IC terminal 4 towards ground 6.

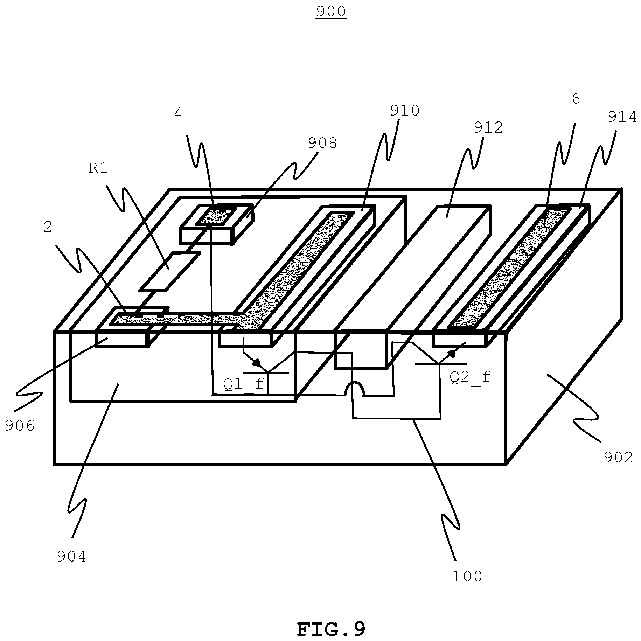

The resistor of the TVS protection device, such as resistor R in the TVS protection device 100, 200, 300, 400, 500, 600, 700 or 800, may be implemented in various manners: as an internal resistor, as an external resistor in an independent structure of a semiconductor substrate, or as an external resistor external to a semiconductor package. Non-limiting examples hereof are shown in Figs. 9-11.

Fig. 9 is a 3D representation of an example TVS protection device 900 with an internal resistor R1. The TVS protection device 900 realizes the unidirectional SCR based TVS protection device 100, which schematics has been overlayed onto the semiconductor representation of Fig. 9. Fig. 9 shows a lowly p doped substrate 902, an n doped region 904, n doped regions 906, 908, a p doped region 910, a p doped region 912 and an n doped region 914. An input terminal in the form of an input connection pad 2 may be connected to the n doped region 906 and the p doped region 910. An IC terminal in the form of an IC connection pad 4 may be connected to the n doped region 908. A ground terminal in the form of a ground connection pad 6 may be connected to the n doped region 914. The n doped region 904, p doped region 910 and p doped region 912 form the transistor Q1_f. The p doped region 912, 902 and n doped region 910, 914 form the transistor Q2_f. The resistor R1 is realized by the n doped region 904 in between the input connection pad 2 and the IC connection pad 4. In this configuration, the resistor R1 may thus be placed in the same doping well that is used to isolate the emitter of the first transistor Q1_f.

A TVS protection device with an internal resistor, such as the TVS protection device 900, is typically part of a single semiconductor package, with three external connection pins or pads formed by or connected to the input connection pad 2, the IC connection pad 4 and the ground connection pad 6. In an example embodiment, a semiconductor package only includes such TVS protection device.

A TVS protection device with an internal resistor, such as the TVS protection device 900, may similarly be realized for other types of TVS protection devices, such as shown in any one of the schematics of Figs. 1-8, mutatis mutandis. A shunt diode, such as the diode D1 in Figs. 5-8, may be added in any manner known per se.

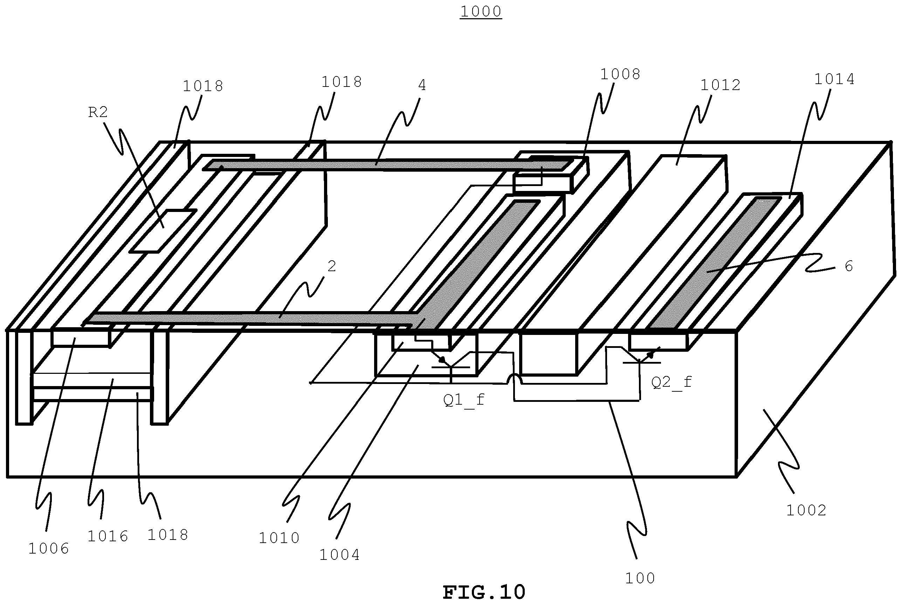

Fig. 10 is a 3D representation of an example TVS protection device 1000 with an external resistor R2 in an independent structure of a semiconductor substrate. The TVS protection device 1000 realizes the unidirectional SCR based TVS protection device 100, which schematics has been overlayed onto the semiconductor representation of Fig. 10. Fig. 10 shows a lowly p doped substrate 1002, an n doped region 1004, n doped regions 1006, 1008, a p doped region 1010, a p doped region 1012, an n doped region 1014, a p doped region 1016 and isolation regions 1018. The isolation may go all around region 1006. An input terminal in the form of an input connection pad 2 may be connected to one side of the n doped region 1006 and the p doped region 1010. An IC terminal in the form of an IC connection pad 4 may be connected to the n doped region 1008 and another side of the n doped region 1006. A ground terminal in the form of a ground connection pad 6 may be connected to the n doped region 1014. The n doped region 1004, p doped region 1010 and p doped region 1012 form the transistor Q1_f. The p doped regions 1012, 1002 and n doped regions 1014, 1004 form the transistor Q2_f. The resistor R2 is realized by the n doped region 1006 in between the input connection pad 2 and IC connection pad 4. In this configuration, the external resistance R2 may be isolated to avoid a parasitic path in one current direction. Hereto, the p doped region 1016 and insulation material 1018 may be arranged below and/or around the n doped region 1006. In this configuration, the resistor R2 may thus be placed in an independent structure, with the two connections of the resistor being connected on the input side (side of input terminal 2) with the emitter of Q1_f and on the IC side (side of IC terminal 4) to the doping well that isolates the emitter of Q1_f.

A TVS protection device with an external resistor in an independent structure of a semiconductor substrate, such as the TVS protection device 1000, is typically part of a single semiconductor package, with three external connection pins or pads formed by or connected to the input connection pad 2, the IC connection pad 4 and the ground connection pad 6. In an example embodiment, a semiconductor package only includes such TVS protection device.

A TVS protection device with an external resistor in an independent structure of a semiconductor substrate, such as shown in Fig. 10, may similarly be realized for other types of TVS protection devices, such as shown in any one of the schematics of Figs. 1-8, mutatis mutandis. A shunt diode, such as the diode D1 in Figs. 5-8, may be added in any manner known per se.

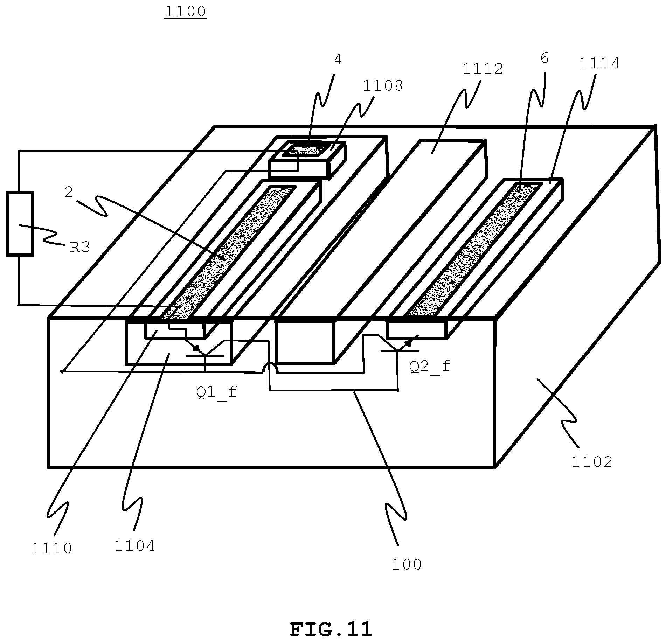

Fig. 11 is a 3D representation of an example TVS protection device 1100 with an external resistor R3, e.g., located on a printed circuit board (PCB) external to the semiconductor package including the semiconductor part of the TVS protection device 1100. The TVS protection device 1100 realizes the unidirectional SCR based TVS protection device 100, which schematics has been overlayed onto the semiconductor representation of Fig. 11. Fig. 11 shows a lowly p doped substrate 1102, an n doped region 1104, an n doped region 1108, a p doped region 1110, a p doped region 1112 and an n doped region 1114. An input terminal in the form of an input connection pad 2 may be connected to the p doped region 1110. An IC terminal in the form of an IC connection pad 4 may be connected to the n doped region 1108. A ground terminal in the form of a ground connection pad 6 may be connected to the n doped region 1114. The n doped region 1104, p doped region 1110 and p doped region 1112 form the transistor Q1_f. The p doped regions 1112, 1102 and n doped regions 1114, 1104 form the transistor Q2_f. The external resistor R3 may be connected, e.g., soldered, between the input connection pad 2 and the IC connection pad 4. In this configuration, the resistor R3 may thus be placed entirely outside the semiconductor device, e.g., onto a PCB board.

A TVS protection device with an external resistor, such as the TVS protection device 1100, typically includes two parts. The first part may include the semiconductor part of the TVS protection device, typically in a single semiconductor package including three external connection pins or pads formed by or connected to the input connection pad 2, the IC connection pad 4 and the ground connection pad 6. The second part is the resistor R3, which may be connected, e.g., soldered, between the input connection pad 2 and the IC connection pad 4 of the first part. In an example embodiment, a semiconductor package only includes such first semiconductor part of the TVS protection device.

A TVS protection device with an external resistor, such as the TVS protection device 110, may similarly be realized for other types of TVS protection devices, such as shown in any one of the schematics of Figs. 1-8, mutatis mutandis. A shunt diode, such as the diode D1 in Figs. 5-8, may be added in any manner known per se.

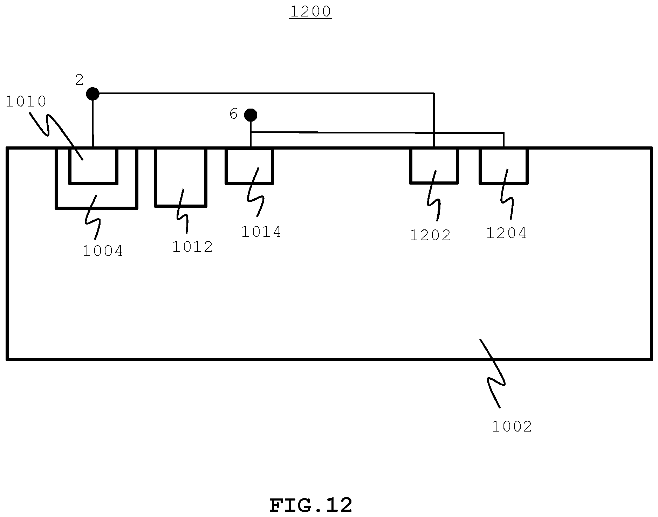

The examples of Figs. 9-11 are for a unidirectional SCR based TVS protection device 100 and are designed to operate in one direction (i.e., a positive pulse is applied to the input terminal 2). For a unidirectional device, such as the TVS protection device 900, a pn junction diode may be integrated to shunt the negative direction to ground. A non-limiting example hereof is shown in Fig. 12, which is based on the schematics of Fig. 5.

Fig. 12 shows a cross-sectional side view of a part of a unidirectional SCR based TVS protection device 1200, similar to the TVS protection device 1000 but with an added shunt diode. The side from the input connection pad 2 is shown, hence the IC connection pad 4 is not visible. The external resistor R2 in the independent structure of the semiconductor substrate is also not visible in Fig. 12. Fig. 12 shows the substrate 1002, n doped region 1004, the p+ doped region 1010, the p doped region 1012 and the n+ doped region 1014 of Fig. 10. Furthermore, the TVS protection device 1200 includes an n+ doped region 1202 and a p+ doped region 1204 forming the shunt diode D1. The input connection pad 2 is connected to the p+ doped region 1010 and the n+ doped region 1202. The ground connection pad 6 is connected to the n+ doped region 1014 and the p+ doped region 1204.

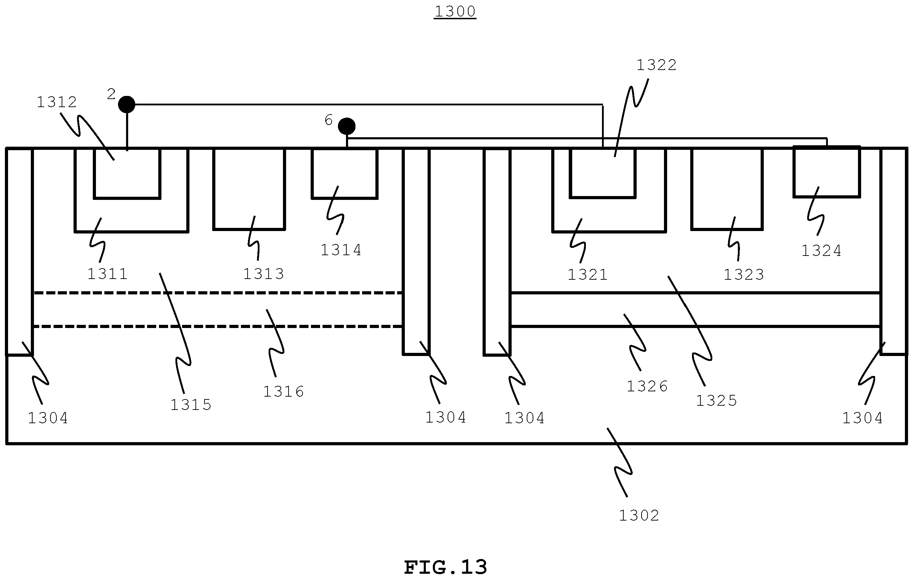

For a bidirectional integrated device, the polarities for the n and p type regions may be inverted for each direction of the TVS protection. A non-limiting example hereof is shown in Fig. 13, which is based on the schematics of Fig. 2.

Fig. 13 shows a cross-sectional side view of a part of a bidirectional SCR based TVS protection device 1300. A side from the input connection pad 2 is shown, hence the IC connection pad 4 is not visible. The resistor R is also not visible in Fig. 13. Fig. 13 shows a substrate 1302 with SCRs for TVS protection in two directions. For one direction, the TVS protection device 1300 includes an n doped region 1311, a p+ doped region 1312, a p doped region 1313 and an n+ doped region 1314. Region 1315 is a p- doped region, which may be identical to the substrate 1302. Optionally, a p doped region 1316 may be arranged below the SCR to block potential leakage. For the other direction, the TVS protection device 1300 includes a p doped region 1321, an n+ doped region 1322, an n doped region 1323 and a p+ doped region 1324. Region 1325 is an n- doped region, which may be arranged on top of an n doped region 1326. The two SCRs may be isolated from each other by insulation material 1304, which may be implemented as deep trench isolation (DTI) regions 1304. The input connection pad 2 is connected to the p+ doped region 1312 and the n+ doped region 1322. The ground connection pad 6 is connected to the n+ doped region 1314 and the p+ doped region 1324.

Various different types of unidirectional or bidirectional TVS protection devices, such as unidirectional SCR based or open transistor based TVS protection devices or bidirectional SCR based or open transistor based TVS protection devices may thus be realized.

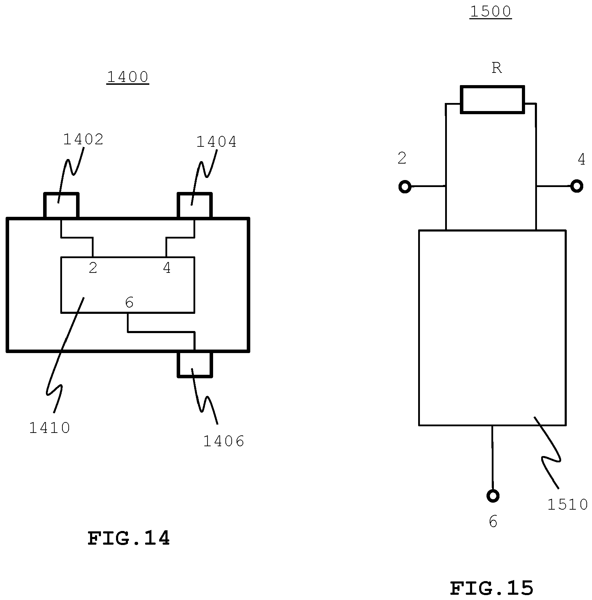

Fig. 14 shows a non-limiting example of a semiconductor package 1400 including a TVS protection device 1410 according to the present disclosure. The TVS protection device 1410 may be any one of the TVS protection devices 100, 200, 300, 400, 500, 600, 700, 800, 900, 1000, 1100, 1200, 1300. Input terminal 2, IC terminal 4 and ground terminal 6 are shown, which, in this example, are located within the semiconductor package 1400 together with the TVS protection device 1410. An internal input terminal 2 may be connected to an external input connection point 1402. An internal IC terminal 4 may be connected to an external IC connection point 1404. An internal ground terminal 6 may be connected to an external ground connection point 6. In another embodiment (not shown), one or more of an input terminal in the form of an input connection pad 2, an IC terminal in the form of an IC connection pad 4 and a ground terminal in the form of a ground connection pad 6 may extend through the semiconductor package 1400.

Generally, the TVS protection device of the present disclosure, including any one of the above examples, may be represented as shown in Fig. 15, where a TVS protection device 1500 is shown including an input terminal 2, an IC terminal 4, a ground terminal 6, a resistance or resistor R in between the input terminal 2 and the IC terminal 4, and a semiconductor device 1510 that may be triggered by a voltage drop across the resistor R to open a path to the ground terminal 6 in case of an overcurrent or overvoltage. A regenerative feedback loop may be created between both sides of the resistor and the semiconductor device 1510 to trigger the TVS protection device in case of an overcurrent or overvoltage.

In any of the above examples, the input terminal 2 and the IC terminal 4 may be reversed, i.e., terminal 2 may be used as an IC terminal and terminal 4 may be used as an input terminal.

Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope thereof.

## Claims

1. A transient voltage suppressor, TVS, protection device (100, 200, 300, 400, 500, 600, 700, 800, 900, 1000, 1100, 1200, 1300, 1410, 1500) comprising:
an input terminal (2);
an integrated circuit, IC, terminal (4);
a ground terminal (6);
a resistor (R, R1, R2, R3) connected between the input terminal and the IC terminal; and
a semiconductor device (1510) arranged to be triggered by a voltage drop across the resistor to open a path between the input terminal and the ground terminal.

2. The TVS protection device (100, 900, 1000, 1100, 1200) according to claim 1,
wherein the semiconductor device comprises a first silicon-controlled rectifier, SCR,
wherein the first SCR comprises a first transistor (Q1_f) and a second transistor (Q2_f),
wherein a collector of the first transistor is connected to the input terminal, wherein an emitter of the first transistor is in a same semiconductor region as a base of the second transistor, wherein a base of the first transistor is connected to a collector of the second transistor and to the IC terminal,
wherein a collector of the second transistor is connected to the base of the first transistor and to the IC terminal, wherein an emitter of the second transistor is connected to the ground terminal, wherein a base of the second transistor is connected to the emitter of the first transistor.

3. The TVS protection device according to claim 1,
wherein the semiconductor device comprises a second SCR,
wherein the second SCR comprises a third transistor (Q1_r) and a fourth transistor (Q2_f),
wherein an emitter of the third transistor is connected to the input terminal, wherein a collector of the third transistor is connected to a base of the fourth transistor, wherein a base of the third transistor is connected to an emitter of the fourth transistor and to the IC terminal,
wherein an emitter of the fourth transistor is connected to the base of the second transistor and to the IC terminal, wherein a collector of the fourth transistor is connected to the ground terminal, wherein a base of the fourth transistor is connected to the collector of the first transistor.

4. The TVS protection device according to claim 2 or claim 3, wherein the TVS protection device is a unidirectional SCR based protection device.

5. The TVS protection device (200, 1300) according to claim 2 and claim 3, wherein the TVS protection device is a bidirectional SCR based protection device.

6. The TVS protection device (300) according to claim 1,
wherein the semiconductor device comprises a first open base transistor, such as a bipolar junction transistor, BJT,
wherein the first open base transistor comprises a fifth transistor (Q1_f), wherein a collector of the fifth transistor is connected to the input terminal, wherein an emitter of the fifth transistor is connected to the ground terminal, wherein a base of the fifth transistor is connected to the IC terminal.

7. The TVS protection device according to claim 1,
wherein the semiconductor device comprises a second open base transistor, such as a bipolar junction transistor, BJT,
wherein the second open base transistor comprises a sixth transistor (Q1_r), wherein an emitter of the sixth transistor is connected to the input terminal, wherein a collector of the sixth transistor is connected to the ground terminal, wherein a base of the sixth transistor is connected to the IC terminal.

8. The TVS protection device according to claim 6 or claim 7, wherein the TVS protection device is a unidirectional open transistor based protection device.

9. The TVS protection device (400) according to claim 6 and claim 7, wherein the TVS protection device is a bidirectional open transistor based protection device.

10. The TVS protection device (500, 700) according to claim 2 or claim 6, further comprising:
a first diode (D1),
wherein a cathode of the first diode is connected to the input terminal, wherein an anode of the first diode is connected to the ground terminal.

11. The TVS protection device (600, 800) according to claim 3 or claim 7, further comprising:
a second diode (D1),
wherein an anode of the second diode is connected to the input terminal, wherein a cathode of the second diode is connected to the ground terminal.

12. The TVS protection device (900) according to any one of the claims 1-11,
wherein the resistor (R1) is an internal resistor formed by a first semiconductor region (904) in between the input connector and the IC connector,
and wherein the first semiconductor region is a part of the semiconductor device.

13. The TVS protection device (1000) according to any one of the claims 1-11,
wherein the resistor (R2) is an external resistor formed by a second semiconductor region (1006) in between the input connector and the IC connector,
and wherein the second semiconductor region is independent from the semiconductor device.

14. The TVS protection device (1100) according to any one of the claims 1-11,
wherein the resistor (R3) is an external resistor in between the input connector and the IC connector,
and wherein the resistor is located outside of a semiconductor package of the TVS protection device.

15. A semiconductor package (1400) comprising a TVS protection device (100, 200, 300, 400, 500, 600, 700, 800, 900, 1000, 1100, 1200, 1300, 1410, 1500) according to any one of the claims 1-13, the semiconductor package comprising at least three externally accessible connection points (1402, 1404, 1406) connecting to an input terminal (2), an integrated circuit, IC, terminal (4) and a ground terminal (6), respectively, of the TVS protection device.
